# EUROPEAN PATENT APPLICATION

(11) **EP 2 180 501 A1**
(43) Date of publication of application: **28.04.2010**
(21) Application number: 08167573.8
(22) Date of filing: 24.10.2008
(51) Int. Cl.: H01J 37/34, C23C 14/34

(54) **Rotatable sputter target base, rotatable sputter target, coating installation, method of producing a rotatable sputter target, target base connection means, and method of connecting a rotatable target base device for sputtering installations to a target base support**

(71) Applicant: Applied Materials, Inc., Santa Clara, CA 95054-3299 (US)
(72) Inventor: Lippert, Lothar, 63755, Alzenau (DE); Heimel, Oliver, 34590, Wabern (DE)
(74) Representative: Zimmermann & Partner

(57) **Abstract**

A rotatable target base device for sputtering installations is provided, wherein the target base device is adapted for receiving thereon a solid target cylinder, the rotatable target base device comprising a target base cylinder (4) having a lateral surface (3), a middle part (12), a first end region (7) and a second end region (9) opposite to the first end region, wherein at least one of the first and the second end regions has a maximum outer diameter substantially equal to or less than the outer diameter of the middle part.

## Description

### FIELD OF THE INVENTION

Embodiments of the invention generally relate to sputtering installations. More particularly, they relate to a rotatable target base device, a rotatable target, a coating installation, a method for producing a rotatable target, a target base connection means, and a method of connecting a rotatable target base device. Specifically, they relate to a rotatable target base device for sputtering installations, a rotatable target for sputtering installations, a coating installation, a method for producing a rotatable target for sputtering installations, a target base connection means for connecting a rotatable target base device for sputtering installations to a target base support, and a method of connecting a rotatable target base device for sputtering installations to a target base support.

### BACKGROUND OF THE INVENTION

Thin-film deposition of material on substrates may be accomplished in many ways, for example by evaporation or sputtering of the coating material in a vacuum chamber. Typical examples of thin-film deposition by sputtering are sputter deposition applications in solar wafer manufacturing or in semiconductor device production.

When operating a sputtering cathode, a plasma is established and ions of the plasma are accelerated onto a target of coating material to be deposited onto the substrates. This bombardment of the target results in ejection of atoms of the coating material, which accumulate as a deposited film on the substrate below the sputtering cathode. In order to obtain increased deposition rates, the use of magnetically enhanced cathodes has been proposed, which may also be referred to as magnetron sputtering.

Typical magnetically enhanced sputtering cathodes may include a flat target plate and an array of magnets mounted in a fixed position relative to the target plate. The magnetic field provided by the magnets establishes the path(s) or the region along which sputtering of the target plate materials takes place.

Other typical magnetically enhanced sputtering cathodes include a cylindrical rotatable tube, e.g. a backing tube, having a layer of the target material applied to the outer surface thereof. Magnetic means, which may include an array of magnets, are arranged inside the tube and provide a magnetic field. The tube is rotatable about its longitudinal axis so that it can be turned relative to the magnetic means to selectively bring different portions or segments of the target material on the outer surface thereof into position opposite to the magnets and within the magnetic field.

In the manufacture of rotatable magnetron sputtering cathodes, the target material may for example be applied by spraying onto the outer surface of a backing tube. Furthermore, the target material of typical sputtering targets may be depleted or consumed quickly, e.g. within a week.

### SUMMARY

In light of the above, a rotatable target base device according to claim 1, a rotatable target according to claim 9, a coating installation according to claim 12, a method for producing a rotatable target according to claim 13, a target base connection means according to claim 14, and a method of connecting a rotatable target base device according to claim 18 are provided.

According to one embodiment, a rotatable target base device for sputtering installations is provided, wherein the target base device is adapted for receiving thereon a solid target cylinder, the rotatable target base device including a target base cylinder having a lateral surface, a middle part, a first end region and a second end region opposite to the first end region, wherein at least one of the first and the second end regions has a maximum outer diameter substantially equal to or less than an outer diameter of the middle part.

According to another embodiment, a rotatable target for sputtering installations is provided, including a rotatable target base device, the target base device being adapted for receiving thereon a solid target cylinder, the rotatable target base device including a target base cylinder having a lateral surface, a middle part, a first end region and a second end region opposite to the first end region, wherein at least one of the first and the second end regions has a maximum outer diameter substantially equal to or less than an outer diameter of the middle part, the rotatable target base device having a solid target cylinder arranged on the lateral surface of the target base cylinder.

According to a further embodiment, a coating installation is provided, including a rotatable target base device, wherein the target base device is adapted for receiving thereon a solid target cylinder, the rotatable target base device including a target base cylinder having a lateral surface, a middle part, a first end region and a second end region opposite to the first end region, wherein at least one of the first and the second end regions has a maximum outer diameter substantially equal to or less than an outer diameter of the middle part.

According to a further embodiment, a method of producing a rotatable target for sputtering installations is provided, including providing a rotatable target base device, the rotatable target base device being adapted for receiving thereon a solid target cylinder, the rotatable target base device including a target base cylinder having a lateral surface, a middle part, a first end region and a second end region opposite to the first end region, wherein at least one of the first and the second end regions has a maximum outer diameter substantially equal to or less than an outer diameter of the middle part; providing a solid target cylinder; and arranging the solid target cylinder on the lateral surface of the target base cylinder.

According to another further embodiment, a target base connection means for connecting a rotatable target base device for sputtering installations to a target base support is provided, including at least one element selected from the group consisting of: a fixation coupling and a fixation recess provided in the target base device, the fixation coupling being adapted for at least partially filling the fixation recess; a clamping means adapted for encompassing the fixation coupling and an adjoined target base support connection means of a target base support; a fixation clamp included in the fixation coupling and being adapted for at least partially filling a fixation recess provided in the target base device; and a fixation collar included in the fixation coupling and having an internal thread corresponding to an external thread provided in a fixation recess provided in the target base device, wherein the fixation recess is provided at an end of the target base device.

According to an embodiment, a method of connecting a rotatable target base device for sputtering installations to a target base support is provided, including providing a rotatable target base device, wherein the target base device is adapted for receiving thereon a solid target cylinder, the rotatable target base device including a target base cylinder having a lateral surface, a middle part, a first end region and a second end region opposite to the first end region, wherein at least one of the first and the second end regions has a maximum outer diameter substantially equal to or less than an outer diameter of the middle part; providing a target base connection means, including a fixation clamp which includes a plurality of annular segmented clamp elements, which are adapted for being closed to a clamp ring, and a plurality of annular segmented clamping shells, which are adapted for encompassing a plurality of annular segmented clamp elements closed to a clamp ring and an adjoined target base support ring of a target base support; mounting the target base connection means at the at least one of the first and the second end regions of the rotatable target base device by closing the plurality of annular segmented clamp elements to a clamp ring; adjoining the clamp ring to a target base support ring of a target base support; and mounting the plurality of annular segmented clamping shells on the adjoined clamp ring and target base support ring such that the annular segmented clamping shells and the annular segmented clamp elements are provided in offset circumferential positions to each other.

Further features and details are evident from the dependent claims, the description and the drawings.

Embodiments are also directed to apparatuses for carrying out the disclosed methods and including apparatus parts for performing described method steps. Furthermore, embodiments are also directed to methods by which the described apparatus operates or by which the described apparatus is manufactured. It may include method steps for carrying out functions of the apparatus or manufacturing parts of the apparatus. The method steps may be performed by way of hardware components, firmware, software, a computer programmed by appropriate software, by any combination thereof or in any other manner.

### BRIEF DESCRIPTION OF THE DRAWINGS

So that the manner in which the above recited features of embodiments can be understood in detail, a more particular description of embodiments of the invention, briefly summarized above, may be had by reference to examples of embodiments. The accompanying drawings relate to embodiments of the invention and are described in the following. Some of the above mentioned embodiments will be described in more detail in the following description of typical embodiments with reference to the following drawings in which:

Fig. 1 shows schematically a cross sectional view of a rotatable target base device for sputtering installations including a solid target cylinder, according to one example of embodiments disclosed herein;

Figs. 2 shows schematically a cross sectional view of a target base cylinder of the rotatable target base device of the example shown in Fig. 1;

Figs. 3a to 3g illustrate schematically the rotatable target base device shown in Fig. 1, provided with an example of a target base connection means, and cross sectional views and top views of the target base connection means according to embodiments disclosed herein;

Fig. 4 shows schematically a cross sectional view of the rotatable target base device shown in Fig. 1 provided with another example of a target base connection means according to embodiments disclosed herein;

Fig. 5 shows schematically a cross sectional view of the rotatable target base device shown in Fig. 1 provided with a further example of a target base connection means according to embodiments disclosed herein;

Fig. 6a to 6e show schematically cross sectional views and top views of another example of a target base connection means according to embodiments disclosed herein;

Fig. 7 shows schematically a cross sectional view of a target base cylinder of the rotatable target base device according to one example of embodiments disclosed herein;

Figs. 8a to 8c illustrate schematically cross sectional views of the rotatable target base device shown in Fig. 7, provided with examples of a target base connection means according to embodiments disclosed herein;

Fig. 9 shows schematically a cross sectional view of the target base connection means according to the example shown in Fig. 8a.

It is contemplated that elements of one embodiment may be advantageously utilized in other embodiments without further recitation.

### DETAILED DESCRIPTION OF THE DRAWINGS

Reference will now be made in detail to the various embodiments, one ore more examples of which are illustrated in the figures. Each example is provided by way of explanation, and is not meant as a limitation of the invention.

Without limiting the scope, in the following the examples and embodiments of the rotatable target base device, the rotatable target, the coating installation, the method for producing a rotatable target, the target base connection means, and the method of connecting a rotatable target base device are described referring to sputtering applications. Typically, the rotatable target base device and the target base connection means include vacuum-compatible materials and the coating installation is a vacuum coating installation. Typical applications of embodiments described herein are for example sputter deposition applications in the production of displays, such as LCD, TFT displays and OLED (Organic Light Emitting Diode), in solar wafer manufacturing and in semiconductor device production.

Within the following description of the drawings, the same reference numbers refer to the same components. Generally, only the differences with respect to the individual embodiments are described.

Without limiting the scope, in the following the target base cylinder of the rotatable target base device will e.g. be referred to as backing cylinder or backing tube. The rotatable target will e.g. include the backing tube and the solid target cylinder.

According to one embodiment, a rotatable target base device for sputtering installations is provided, wherein the target base device is adapted for receiving thereon a solid target cylinder, the rotatable target base device including a target base cylinder having a lateral surface, a middle part, a first end region and a second end region opposite to the first end region, wherein at least one of the first and the second end regions has a maximum outer diameter substantially equal to or less than an outer diameter of the middle part.

The target base device is for example suitable for concentrically arranging a solid target cylinder on the target base cylinder. Further, the solid target cylinder may be a hollow cylinder or a plurality of hollow cylinders arranged one after the other on the target base cylinder. By arranging the solid target cylinder(s) on the target base cylinder, typically a rotatable target results. The rotatable target base device may be used for a substantially vertical mounting of a rotatable target in a sputtering installation. Typically, the lateral surface of the target base cylinder may be understood as the cylinder barrel or the mantle of the cylinder.

Embodiments disclosed herein allow for providing a target, which may be a solid target cylinder, e.g. a solid target material tube, on a backing cylinder, e.g. a backing tube, since access from at least one end of the backing cylinder is possible. This is due to the structure of the backing cylinder, in which at least one end region of the backing cylinder has a maximum outer diameter substantially equal to or less than the outer diameter of the middle part of the backing cylinder. Therefore, a cylindrical solid target having an inner diameter matching the outer diameter of the middle part of the backing cylinder may be easily placed concentrically on the backing cylinder. The target may be designed for use as a bonded or non-bonded target. Hence, in some examples, a solid target may be provided on a backing tube of the sputtering cathode by bonding, which may require bonding material. Furthermore, in contrast to backing cylinders for sprayed targets, using embodiments disclosed herein makes it possible to array a plurality of cylindrical, e.g. tubular, solid targets or targets sleeves for bonded or non-bonded targets on a backing cylinder. Moreover, the rotatable target base device and backing cylinder, respectively, according to embodiments disclosed herein, may be used repeatedly and may be restored just by exchanging the cylindrical targets. This is especially suitable for rotatable targets having a target material which is depleted quickly during coating applications.

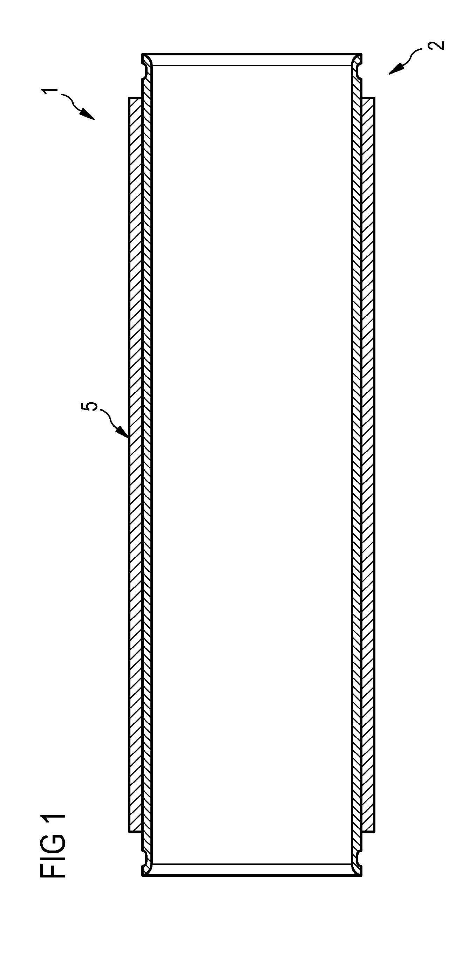

Figs. 1 shows schematically a rotatable target 1 for sputtering installations according to one example of embodiments disclosed herein. The rotatable target 1 typically includes a rotatable target base device 2 and a tubular solid target 5 as a solid target cylinder, also referred to herein as target 5.

In examples of embodiments disclosed herein, the inner diameter of the solid target cylinder 5 may be substantially equal to or larger than the outer diameter of the middle part of the target base cylinder. Typically, the target 5 may have an outer diameter of about 100 mm to about 200 mm, more typically of about 130 mm to about 170 mm, most typically of about 145 mm. The inner diameter of the target 5 may be in the range of about 80 mm to about 180 mm, more typically of about 110 mm to about 150 mm, most typically of about 133 mm. The thickness of the target may be in the range of about 2 mm to about 30 mm. Typically, the target 5 may have a thickness of about 3 to 20 mm, more typically about 5 to 17 mm, most typically about 6 to 12 mm. Moreover, the length of the target 5 may be in a range of about 240 mm to about 3500 mm, more typically of about 1360 mm to about 1400 mm, about 1560 to about 1600 mm, about 1660 mm to about 1700 mm, about 2010 mm to about 2050 mm, or about 2500 mm to about 2540 mm. The outer diameter of the backing tube 4 in the middle part 12, i.e. in the region of the lateral surface 3, may be in the range of about 80 mm to about 180 mm, more typically of about 110 mm to about 150 mm, most typically of about 133 mm. The inner diameter of backing tube 4 may be in the range of about 60 m to about 160 mm, more typically of about 90 mm to about 130 mm, most typically of about 125 mm. Typically, the length of the backing tube 4 may be in a range of about 300 mm to about 3600 mm, more typically about 1440 mm, about 1640 mm, about 1740 mm, about 2090 mm, about 2240 mm, about 2580 mm, or about 3600 mm. In some examples of embodiments disclosed herein, the outer and/or inner diameters of the middle part 12 of the backing tube 4 are substantially constant over the length of the middle part 12. Further, in some examples of embodiments disclosed herein, the outer and/or inner diameters of the target 5 are substantially constant over the length of the target 5.

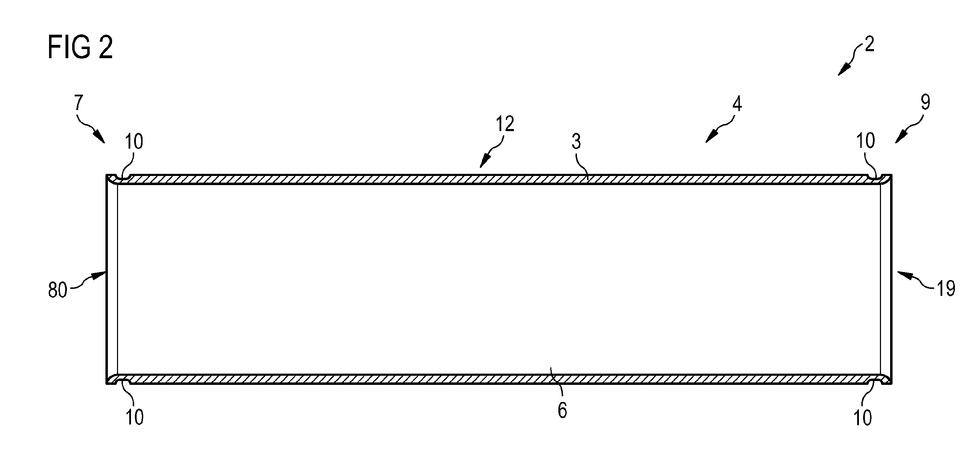

The rotatable target base device 2 of the rotatable target 1 illustrated in Fig. 1 is further schematically shown in Fig. 2 without a target 5 arranged thereon. The rotatable target base device 2 includes a backing tube 4. In some examples of embodiments disclosed herein, at least one end region of the backing tube has a maximum outer diameter substantially equal to or less than an outer diameter of the middle part.

Backing tube 4 of the present example has a middle part 12 with a lateral surface 3 and further has a first end region 7 and a second end region 9. In the present example, both the first and the second end regions 7, 9 have a maximum outer diameter substantially equal to the outer diameter of the middle part, typically at the lateral surface 3 of the backing tube 4. Moreover, backing tube 4 may have in each end region 7 and 9 an opening 80, 19. Furthermore, backing tube 4 may include an interior space 6 for containing at least one element selected from the group consisting of a magnet device and a cooling system.

In one example of embodiments disclosed herein, the rotatable target base device may comprise at least one target base connection means being adapted for connecting the target base cylinder to a target base. Hence, at least one target base connection means may be provided at at least one of the first and the second end regions of the target base device. In a variation of this example, at least one of the target base connection means may be removable.

In some examples of embodiments disclosed herein, one or both end regions of the target base cylinder of the target base device may have a maximum outer diameter substantially equal to or less than an outer diameter of the middle part and may be provided with a target base connection means.

As a result, for instance in the example shown in Figs. 1 and 2, the target 5 may easily be installed at the target base device 2 shown in Fig. 1, even if the inner diameter of the target 5 is substantially equal to or just slightly larger than the outer diameter of the backing tube 4. This is due to the fact that for installing the target 5, at one end of the backing tube, the end having a maximum outer diameter substantially equal to or less than the outer diameter of the middle part of the backing tube, the target base connection means may be removed. The target 5 may then concentrically be placed on the backing tube 4 and pushed in parallel to the rotational axis of the backing tube 4 to a desired position. In the present example, the longitudinal central axis of the backing tube 4 is the rotational axis thereof.

The target base connection means may be adapted for connecting the target base cylinder to a target base support. In one example of embodiments disclosed herein, each of the first and the second end regions may be provided with one of the target base connection means, in order to connect the target base cylinder with two target base supports. In a further example, one or both of the target base supports may be part of a rotational target base drive system, which may further provide supply of e.g. a cooling fluid or power supply to the interior space of the target base cylinder.

According to a typical example, at least one of the first and the second end regions of the target base cylinder may be adapted for being provided with one of the target base connection means.

According to a typical example disclosed herein, the at least one target base connection means may include a clamping means adapted for connecting the target base cylinder to a target base support. More typically, the at least one target base connection means may include a fixation coupling, and a fixation recess provided in the target base cylinder, the fixation coupling being adapted for at least partially filling the fixation recess. Moreover, the clamping means may be adapted for encompassing the fixation coupling and an adjoined target base support connection means of a target base support. The fixation coupling may in one example be formed as a fixation clamp which may have at its inner circumference a protrusion matching the fixation recess. At least one of the first and second end regions of the target base cylinder may include one fixation recess provided in the lateral surface of the target base cylinder.

According to another further embodiment, a target base connection means for connecting a rotatable target base device for sputtering installations to a target base support is provided, including at least one element selected from the group consisting of: a fixation coupling and a fixation recess provided in the target base device, the fixation coupling being adapted for at least partially filling the fixation recess; a clamping means adapted for encompassing the fixation coupling and an adjoined target base support connection means of a target base support; a fixation clamp included in the fixation coupling and being adapted for at least partially filling a fixation recess provided in the target base device; and a fixation collar included in the fixation coupling and having an internal thread corresponding to an external thread provided in a fixation recess provided in the target base device, wherein the fixation recess is provided at an end of the target base device.

As shown in the example of Fig. 2, the target base cylinder 4, also referred to herein as backing tube, includes at each end region 7 and 9 a recess 10. As mentioned above, in the present example, both the first and the second end regions 7, 9 have a maximum outer diameter substantially equal to the outer diameter of the middle part. The recesses 10 are provided in the lateral surface 3 of the backing tube 4. According to typical examples of embodiments disclosed herein, the recesses 10 are annular.

The clamping means according to embodiments disclosed herein, which is adapted for connecting a target base device for sputtering installations to a target base support, as well as the rotatable target base device of embodiments disclosed herein, which includes such a clamping means as a target base connection means, respectively, are useful for clamping a target backing cylinder in a system, e.g. in a rotatable drive system, of coating and/or sputtering installations.

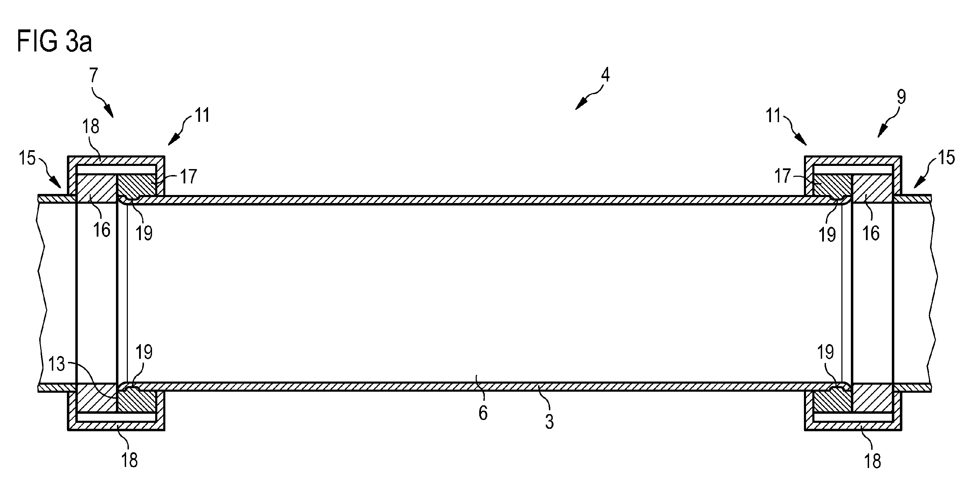

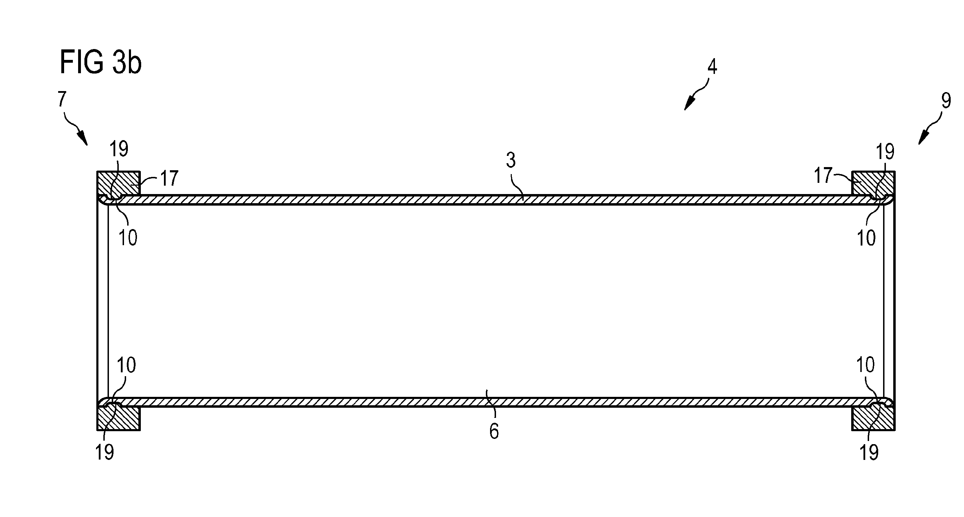

Figs. 3a and 3b illustrate one typical example of embodiments disclosed herein, in which the rotatable target base device 2 shown in Fig. 2 is provided with two target base connection means 11. The first end region 7 and the second end region 9 of the backing tube 4 are in the present example each provided with one of the target base connection means 11. Typically, one or both target base connection means 11 may be removable from the backing tube 4. In the present example, each target base connection means 11 is removable and includes as a fixation coupling a fixation clamp formed as a clamp 17 and as a clamping means a clamping shell 18.

In the example shown in Figs. 3a to 3g, the clamp 17 and the clamping shell 18 are annular. Typically, according to examples of embodiments disclosed herein, the target base cylinder is a tubular base cylinder, and at least one element selected from the group consisting of the target base connection means, the clamping means, the fixation clamp, the fixation recess, and the target base support connection means may be annular. Moreover, in embodiments disclosed herein, the clamping means and/or the fixation clamp, respectively, may include a segmented structure.

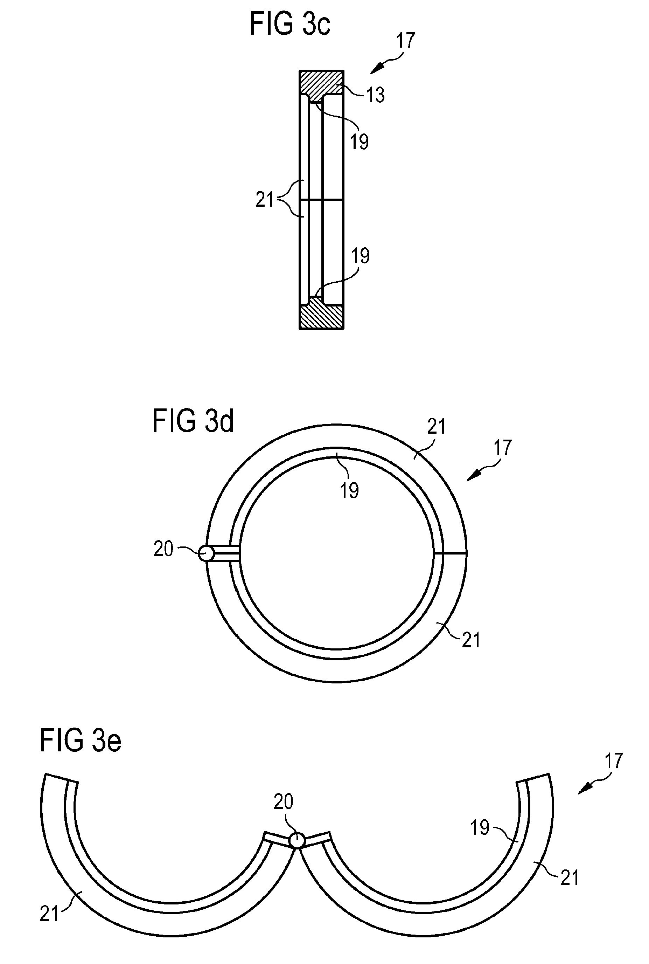

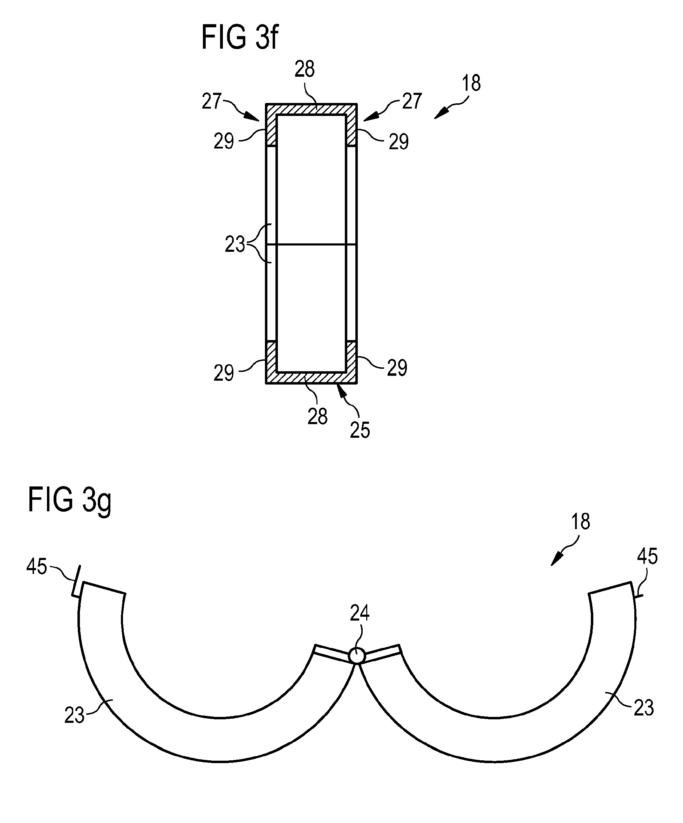

Figs. 3a illustrates a typical example of the backing tube 4 and the target base connection means 11 of the rotatable target base device 2 in an assembled state. In this example, the backing tube 4 is connected at each end region to a target base support 15 having an annular flange 16 as a target base support connection means. The tubular solid target 5 of rotatable target 1 is not shown. Furthermore, at each of the end regions 7 and 9, one annular clamp 17 is clamped to the backing tube. Each clamp 17 has an inner protrusion 19 and an inner diameter such that in each annular recess 10 an inner protrusion 19 of the corresponding annular clamp 17 is provided. The cross sectional view of Fig. 3c illustrates the inner protrusion 19 of the annular clamp 17 and a contact side 13 of clamp 17, at which clamp 17 may be adjoined to flange 16 of the target base support. Moreover, in the assembled state as shown in Fig. 3a, over each of clamps 17 one annular clamping shell 18 having an outer diameter being larger than the outer diameter of the clamp 17 is mounted. The clamping shell 18 is further illustrated in Fig. 3f and includes an outer ring 25 provided at each side with two annular span elements 27. The width of the clamping shell 18, i.e. the width of ring 25, is such that it spans the sum of the widths of the clamp 17 and the flange 16 of the target base support 15. Therefore, in the assembled state, the two annular span elements 27 encompass clamp 17 and the flange 16, which may include a vacuum seal (not shown), and fix the backing tube 4 and the target base supports 15 to each other by a clamping tension. Thereby, a vacuum tight seal may be provided between the backing tube 4 and each of the target base supports 15 using two target base connection means 11.

In a typical example of embodiments disclosed herein, the width of the clamping shell 18, e.g. the width of ring 25, may be equal to or slightly smaller than the sum of the widths of the clamp 17 and the flange 16. Hence, an interference fit or press fit between clamping shell 18 and the combination of clamp 17 and flange 16 may be provided. Consequently, clamping shell 18 may be fixed to clamp 17 and flange 16, which are adjoined to each other, by a press fit fixation.

In the present example, the height of clamp 17, i.e. the dimension of the annular collar of clamp 17 perpendicular to the longitudinal axis of backing tube 4, when clamp 17 is mounted thereon, typically corresponds to the height of the annular collar of flange 16. Therefore, clamp 17 and flange 16 may be aligned at the outer circumferences thereof. For instance, the height of the annular collar of clamp 17 may be in a range of about 10 mm to about 50 mm.

Typically, the clamp may include a plurality of segmented clamp elements, and/or the clamping shell may include a plurality of segmented clamp shells. More typically, the clamp may include annular segmented clamp elements, and/or the clamping shell may include annular segmented clamp shells. The clamp and the clamping shell may be annular. Generally, annular segmented elements have lengths and radii such that, when longitudinally aligned with each other and viewed, an annulus is seen by the viewer. Most typically, the annular segmented clamp elements, and/or the annular segmented clamp shells may be semiannular, also referred to herein as semicircular. Furthermore, the segmented clamp elements or annular segmented clamp elements may be hinged to each other, and/or the segmented clamp shells or annular segmented clamp shells may be hinged to each other.

According to embodiments disclosed herein, the target base connection means including a clamping means allows to fix a bonded or non-bonded solid cylindrical target installed at a target base device, e.g. at a backing tube, in an existing clamping system of a coating installation. In one example of embodiments, the target base connection means may include a fixation clamp including a plurality of segmented clamp elements and/or a clamping shell including a plurality of segmented clamping shells. However, in some embodiments, the fixation clamp and/or the clamping shell may each be made in one piece. This piece may have a flexible structure, in order to allow concentrically arranging the fixation clamp and/or the clamping shell on the target base device and on a clamp installed on the target base device, respectively.

As illustrated above, the target base connection means of embodiments disclosed herein does not require a spring. Therefore, the target base connection means of embodiments disclosed herein is easy to install at the backing tube and the target base support, when they are adjoined to each other. In addition, when using the target base connection means of embodiments disclosed herein, no further fixation, e.g. using screws, is required to install the rotatable target including the backing tube in a coating installation. Moreover, the segmented structure of embodiments of the target base connection means also promotes a convenient installation of the backing tube at the target base support.

In the example shown in Figs. 3a to 3g, the clamp 17 has, as segmented clamp elements 21, two semicircular clamp elements 21, which are hinged to each other by a hinge 20. The semicircular clamp elements 21 may be closed to a ring, as illustrated in the top views of Figs. 3d and 3e showing the clamp 17. Moreover, as shown in Fig. 3f and 3g, the clamping shell 18 of the present example includes, as segmented clamping shells, two semicircular clamping shells 23. The semicircular clamping shells 23 are hinged to each other at a hinge 24 and may be closed to a ring, e.g. forming a clamp collar. According to the present example, the semicircular clamping shells 23 may be secured to each other by a fastener 45.

The segmented structure of the clamp 17, according to the present example of embodiments disclosed herein, allows closing the two semicircular clamp elements 21 around the backing tube 4 while positioning the protrusion 19 in the annular recess 10. In examples of embodiments disclosed herein, the inner diameter of closed clamp 17 is suitably chosen, e.g. it is substantially equal to or slightly larger than the diameter of recess 10, in order to provide a good match of the clamp 17 and the recess 10.

Furthermore, the clamping means of embodiments described herein has dimensions and inner diameters allowing installation of the clamping means around the fixation coupling of the target base connection means and an adjoined target base support connection means of a target base support. For instance, the width and the inner diameters of clamping shell 18 allow an installation thereof around clamp 17 and flange 16 of the target base support 15, when clamp 17 and flange 16 are adjoined to each other, as shown in Fig. 3a. In one example shown in Figs. 3f and 3g, the clamping shell 18 includes two semicircular clamping shells 23 each having an outer semicircular element 28 and two lateral semicircular span elements 29 attached laterally to the outer semicircular element 28. The outer ring 25, which is formed by the outer semicircular elements 28 when closing the clamping shell 18, may have an inner diameter larger than the outer diameter of the clamp 17 and the outer diameter of flange 16. Moreover, the inner diameters of the two annular span elements 27, which are formed by the lateral semicircular span elements 29 when closing the clamping shell 18, may match or be larger than the outer diameters of the backing tube 4 and of a flange socket of the target base support 15, at which the flange 16 is mounted, respectively, as shown in Fig. 3a.

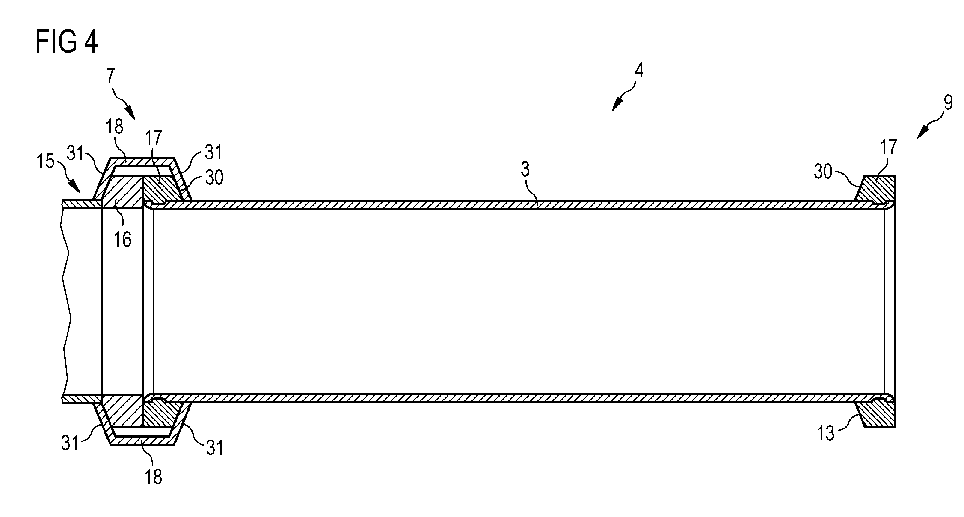

According to one example of embodiments disclosed herein, the target base connection means and/or the target base support may include chamfered clamping areas. For instance, a clamp of the target base connection means, and/or a connector of the target base support, e.g. a connector ring or an annular collar, may have chamfered outer clamping areas. Further, a clamping means of the target base connection means, e.g. clamping shell 18, may have chamfered inner clamping areas. As illustrated in Fig. 4, according to a variation of the example shown in Figs. 3a to 3g, the clamp 17 on the backing tube 4 and the flange 16 of the target base support 15 may have chamfered edges resulting in chamfered side faces 30, 31, respectively. The chamfered side face 30 of clamp 17 is positioned opposite to the contact side 13 of the clamp 17. Further, the chamfered side face 31 of the flange 16 is located opposite to the contact side of flange 16, i.e. the flange side which will contact the contact side 13 of clamp 17. Moreover, the annular span elements 27 of clamping shell 18 may be correspondingly inclined, so as to span the chamfered side faces 30 and 31, when clamp 17 and flange 16 are adjoined. Thereby, the annular span elements 27 may fix clamp 17 and flange 16 in a vacuum tight way, when clamp 17 installed at the backing tube 45 and flange 16, which may include a vacuum seal (not shown), are adjoined to each other and clamping shell 18 is clamped over them.

The chamfered side face 30 of clamp 17 may have an angle of inclination in relation to the lateral surface 3 of the backing tube 4 in the range between about 100° and about 120°, typically about 105°, when clamp 17 is installed at the backing tube 4. The chamfered side face 31 of flange 16 may have an angle of inclination in relation to the flange socket of the target base support 15 in the range between about 100° and about 120°, typically about 105°. The annular span elements 27 of clamping shell 18 may have a corresponding or even smaller angle of inclination in relation to the ring 25 as compared to the angle of inclination of the side faces 30, 31. Thereby, a clamping tension may be established, when clamping shell 18 is mounted on clamp 17 and flange 16 adjoined to each other. For instance, one span element 27 may have an angle of inclination in relation to the ring 25 in the range between about 95° and about 120°, typically about 105°, and the other span element 27 may have an angle of inclination in relation to the ring 25 in the range between about 95° and about 120°, typically about 105°. Hence, when clamping shell 18 is clamped over the combination of clamp 17 and flange 16 by a press fit fixation, the angle of inclination of span elements 27 may be increased and may then correspond to the angle of inclination of the side faces 30, 31, thereby providing a clamping tension.

Because of the chamfered clamping areas, the installation of the target base connection means may be promoted. E.g. in the example of Fig. 4, the chamfered side faces 30, 31 and the chamfered annular span elements 27 allow for pushing clamping shell 18 on the adjoined clamp 17 and flange 16. Thereby, a convenient fixation of the rotatable target base device 2 to the target base support 15 results.

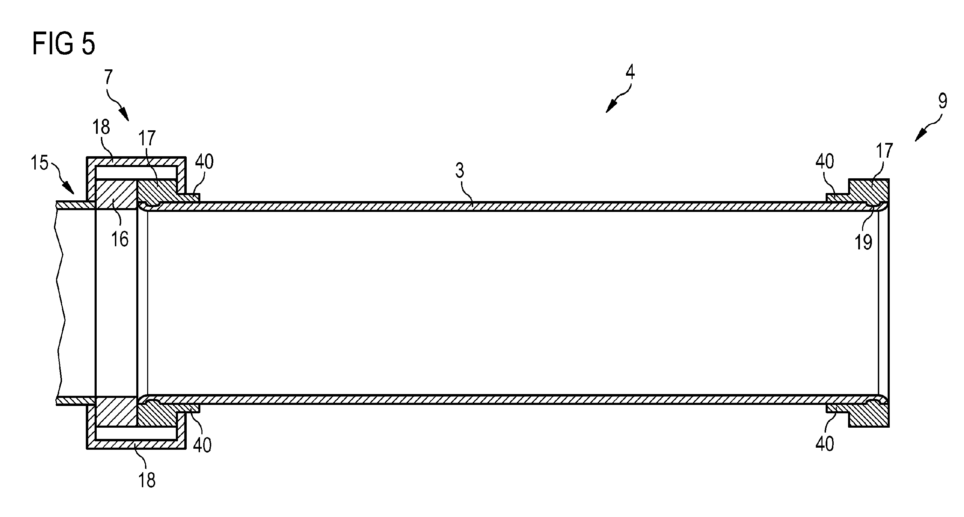

According to another example of embodiments disclosed herein, at least one target base connection means of the rotatable target base device may include a target fixation means, the target fixation means optionally being a spacer means provided at the fixation clamp. An example is illustrated in Fig. 5 and differs from the one of Fig. 3a to 3g in that at clamp 17, as the spacer means, a spacer 40 is attached. As shown in Fig. 5, when backing tube 4 and two clamps 17 including the spacer 40 are assembled, the spacers 40 are provided adjacent to the lateral surface 3 of the backing tube 4. Hence, when target 5 is concentrically provided at the lateral surface 3, it is located in the present example between two spacers 40 which fix the target 5 in its position. One or both spacers 40 may be annular. In an alternative example, one or both spacers 40 may each include a plurality of spacer elements attached laterally at the clamp. According to another example, one or both spacers 40 may be spacer rings provided separately in addition to the clamp(s) 17. The width of the spacer 40, i.e. the width in a direction in parallel to the rotational axis of the backing tube 4 when the clamp 17 is mounted thereon, may be in a range of about 2 mm to about 50 mm, and may be more typically in a range of about 20 mm to about 40 mm. The height of the spacer 40, i.e. the dimension perpendicular to the width of the spacer and perpendicular to the lateral surface 3 of the backing tube 4 when clamp 17 is mounted thereon, may be in a range of about 15 mm to about 50 mm.

Further, the one or more spacers 40 provide gaps between clamping shells 18 and the target 5. The gaps may have a width of typically about 2 mm to about 50 mm, more typically in a range of about 20 mm to about 40 mm. Thereby, thermal expansion of the target 5 in parallel to the rotational axis, i.e. in the present example the longitudinal axis, of the backing tube 4 may be possible and detrimental effects of such a thermal expansion may be avoided. Further, an optimal position, e.g. a centered position, of the tubular solid target 5 in parallel to the rotational axis of the rotatable target 1 may be achieved. The spacers 40 hold the target 5 in a fixed position, even though gaps between the clamping shells 18 and the target 5 are provided.

In a variation of the present example, at the backing tube, only one fixation means including the clamp 17 with the spacer 40 may be provided at one end of backing tube 4, when the target 5 is disposed on the lateral surface 3. At the other end region of backing tube 4, e.g. a clamp 17 without a spacer may be installed. Thereby, one gap is provided between the target 5 and one of the clamping shells 18 of the connection means connecting the backing tube 4 to a target base support 15.

For instance, according to a typical example of embodiments disclosed herein, one of the clamps 17 including the spacer 40 is provided at the end region of backing tube 4, which is positioned at the bottom of the rotatable target 1 including the backing tube 4 and the target 5, when the rotatable target 1 is mounted vertically in a coating device for sputtering applications. This is particularly useful for non-bonded targets, since the spacer 40 acts as a fixing shoulder for holding the non-bonded target in position. More particularly, when non-bonded targets are installed together with one or more bonding rings, the bonding ring(s) may be held in its or their position by spacer 40 or spacers 40, respectively.

Hence, embodiments and examples of embodiments disclosed herein are suitable for a substantially vertical mounting of the rotatable target 1 in a sputtering installation. This applies especially to the examples of a target base connection means including one or more spacers 40, since the spacer 40 or spacers 40, respectively, provide for a reliable positioning, alignment, centering and even fixation of the tubular solid target 5.

In a further variation of the example of the target base connection means shown in Fig. 5, the clamp 17, which includes the spacer 40, and the flange 16 of the target base support 15 may have chamfered side faces as described above with respect to Fig. 4. Moreover, the annular span elements 27 of clamping shell 18 may be correspondingly inclined, so as to span the chamfered side faces 30 and 31, when flange 16 and clamp 17 are adjoined. Further, the inner diameters of the two annular span elements 27, which are formed by the lateral semicircular span elements 29 when closing the clamping shell 18, may be adapted correspondingly. For instance, the inner diameter of the span element 27 of clamping shell 18 facing the target in the assembled state may match or be larger than the outer diameter of the spacer 40.

As typical examples of a target material used in embodiments disclosed herein, the target 5 may include ITO (Indium Tin Oxide), or Silicon, e.g. 5N or 3N quality, which may be doped with Boron, e.g. Z-600.

According to a further embodiment, a method of producing a rotatable target for sputtering installations is provided, including the steps of providing a rotatable target base device for sputtering installations, wherein the target base device is adapted for receiving thereon a solid target cylinder, the rotatable target base device including a target base cylinder having a middle part with a lateral surface, and further having a first end region and a second end region opposite to the first end region, wherein at least one of the first and the second end regions has a maximum outer diameter substantially equal to or less than the outer diameter of the middle part; providing a solid target cylinder; and arranging the solid target cylinder on the lateral surface of the target base cylinder. The method may further include, e.g. after the step of arranging the solid target cylinder, a step of installing at the at least one of the first and the second end region of the target base cylinder a target base connection means.

Typically, the solid target cylinder may be a hollow cylinder or a plurality of hollow solid cylinders provided adjacent to each other. The solid target cylinder or the plurality of solid cylinders may be arranged concentrically on the target base cylinder. Typically, by combining the solid target cylinder and the target base cylinder(s) according to above further embodiment, the rotatable target is formed. The rotatable target may be for a substantially vertical mounting of a sputtering target in a sputtering installation.

In one example of embodiments described herein, backing tube 4 shown in Fig. 2 is provided. Then, tubular solid target 5 is concentrically placed e.g. on the second end region 9, moved in parallel to the central axis, i.e. in the present example a rotational axis, of the backing tube 4 and positioned centrally thereon. Then, at each end region 7 and 9 of the backing tube 4, as target base connection means, one clamp 17, including two hinged semicircular clamp elements 21, may concentrically be positioned. In this position the protrusion 19 of each clamp 17 fills one of the recesses 10 of the backing tube 4. Each clamp 17 may be fixed at backing tube 4 by closing around clamp 17 and adjoined flange 16 of the target base support one of the clamping shells 18 and fastening it by fastener 45. As a result, tubular solid target 5 is positioned between clamps 17, providing the rotatable target 1.

In a variation of the above example, only one fixation clamp 17 may be installed at one end region of backing tube 4 after concentrically placing the tubular target 5 thereon. This may e.g. be done, when restoring the rotatable target 1 for replacing a depleted target 5, as will be described below. The above variation of the method may also be used, if the other end region of backing tube 4 is already provided with a target base connection means or any other end piece, for example a flange welded to the other end region of backing tube 4.

According to a yet further embodiment, a method of restoring a rotatable target for sputtering installations may be provided, including the steps of providing a rotatable target for sputtering installations, the rotatable target including a rotatable target base device including a target base cylinder having a middle part with a lateral surface, and further having a first end region and a second end region opposite to the first end region, wherein at least one of the first and the second end regions has a maximum outer diameter substantially equal to or less than the outer diameter of the middle part, the rotatable target base device having a solid target cylinder arranged on the lateral surface of the target base cylinder and a target base connection means arranged on the at least one end region; dismounting the target base connection means from the at least one end region of the target base cylinder; dismounting the solid target cylinder; providing another solid target cylinder; arranging the another solid target cylinder on the lateral surface of the target base cylinder; and installing the target base connection means at the at least one end region of the target base cylinder. The target base connection means of this embodiment may be a fixation clamp including the clamp 17 and the clamping shell 18 of any example as described above.

For instance, the second end region 9 of backing tube 4 has a maximum outer diameter substantially equal to or less than the outer diameter of the middle part 12. Therefore, a tubular solid target 5, which e.g. may have an inner diameter slightly larger than the outer diameter of the middle part of the backing tube, can be placed on the lateral surface 3 of the backing tube 4 by concentrically arranging it on the second end region 9. Then, it may be positioned in a desired position by moving or pushing it on the backing tube 4 along the rotational axis, i.e. in the present example the longitudinal axis, of the backing tube.

Further, the solid target cylinders may be hollow cylinders. The solid target cylinders may be arranged concentrically on the target base cylinder. Typically, by treating and combining the solid target cylinders and the target base cylinder according to above yet further embodiment, the rotatable target is restored.

Embodiments disclosed herein allow for providing a cylindrical target, which may be a solid target material tube, on a backing cylinder, e.g. a backing tube, since access from at least one end of the backing cylinder is possible. This is due to the structure of the backing cylinder, in which at least one end region of the backing cylinder has a maximum outer diameter substantially equal to or less than the outer diameter of the middle part of the backing cylinder. The target may be designed for use as a bonded or non-bonded target. With embodiments disclosed herein, a cylindrical or tubular solid target having an inner diameter matching the outer diameter of the lateral surface of the middle part may be easily placed on the backing cylinder. As a result, in some examples of embodiments, expensive bonding of a solid target to a backing cylinder may be avoided, the more so as use of extensive bonding material is not required. In other examples, a solid target may be provided on a backing tube of the sputtering cathode by bonding. Furthermore, in contrast to backing tubes for sprayed targets, using embodiments disclosed herein makes it possible to array a plurality of cylindrical or tubular solid targets or targets sleeves for bonded or non-bonded targets on a backing tube. Moreover, the rotatable target base device and backing tube, respectively, according to embodiments disclosed herein, may be used repeatedly and may be restored just by exchanging the cylindrical targets. This is especially suitable for rotatable targets having a target material which is depleted quickly during coating applications. Moreover, the rotatable target base device may be used for a substantially vertical mounting of a rotatable target in a sputtering installation.

Furthermore, since, according to some examples of embodiments, one or more target base connection means having a target fixation means may be provided, which allows for a gap between the cylindrical solid target and the target base connection means, the thermal expansion coefficient between the backing cylinder material and the target material may be different. In addition, in examples of embodiments, which include the target base connection means, the target may be fixed to the backing cylinder, or even centered or aligned on the backing cylinder in a desired position.

According to one example of embodiments disclosed herein, the target base connection means may include a fixation clamp including a plurality of annular segmented clamp elements adapted for being closed to a clamp ring, and a clamping means including a plurality of annular segmented clamping shells adapted for encompassing a plurality of annular segmented clamp elements closed to a clamp ring and an adjoined target base support ring of a target base support, at least one of the plurality of annular segmented clamp elements including an adjustment means adapted for mounting the plurality of annular segmented clamping shells on the adjoined clamp ring and target base support ring such that the annular segmented clamping shells and the annular segmented clamp elements are provided in offset circumferential positions to each other, wherein the adjustment means is optionally provided at the outer circumference of at least one of the annular segmented clamp elements.

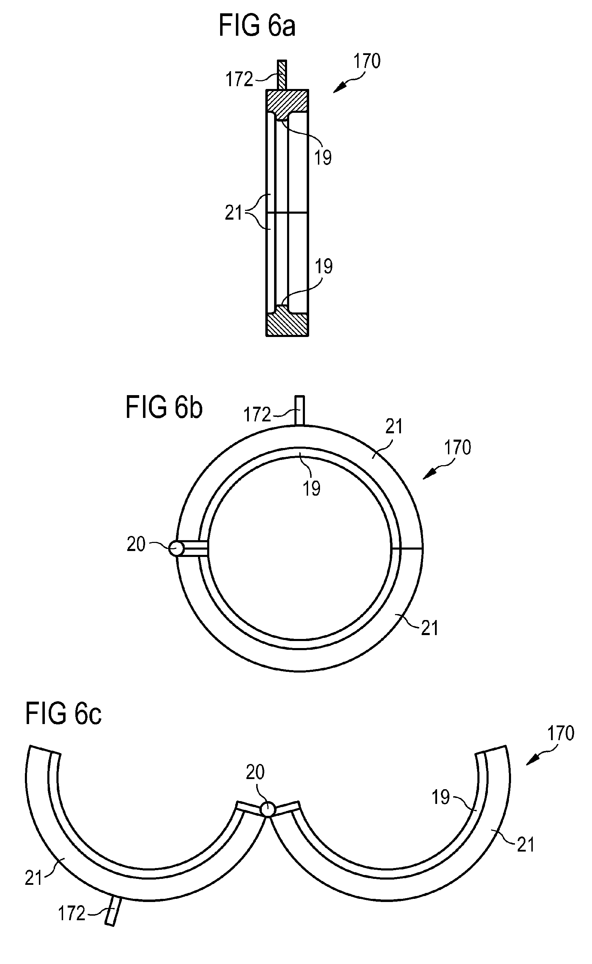

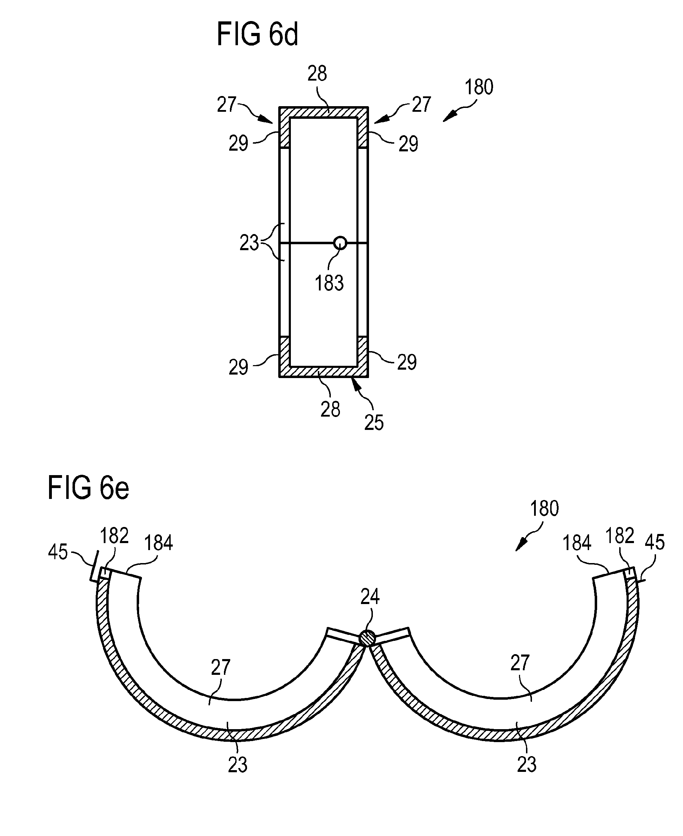

For instance, in the example of the target base connection means 11 shown in Figs. 3a to 3g, instead of clamp 17 and clamping shell 18, the fixation clamp may include clamp 170 and clamping shell 180 shown in Fig. 6a to 6e. As an adjustment means, a pin 172 may be provided at the outer circumference of one semicircular element 21 of clamp 170, e.g. between the ends of one clamp element 21, typically in the middle of the semicircle of span element 21, as shown in Fig. 6b and 6c. Clamping shell 180 may include at free ends 184 of the two semicircular clamping shells 23 two openings 182, one opening 182 at each free end 184. Clamping shell 180 is shown in Fig. 6e in a cross sectional view, illustrating the position of the openings 182. Openings 182 form a combined opening 183 at the interface of free ends 184 of the clamping shell 180 in its closed state as illustrated in Fig. 6d. The pin 172 may be formed to fill the combined opening 183, which is a combination of openings 182, when clamping shell 180 is closed around clamp 170.

Alternatively, in a variation of the above example, the adjustment means may be a mark (not shown), e.g. a colored dot, located instead of pin 172 at the outer circumference of one semicircular element 21 of clamp 170. The clamping shell 180 may be formed, e.g. may have lengths of the clamping shells 23, to provide a gap between the free ends 184, when it is closed. The gap allows optical inspection of the outer circumference of an underlying semicircular element 21, when clamping shell 180 is closed around clamp 170, for checking whether the mark is positioned beneath the gap of clamping shell 180.

In another embodiment, a method of connecting a rotatable target base device for sputtering installations to a target base support is provided, including providing a rotatable target base device for sputtering installations, wherein the target base device is adapted for receiving thereon a solid target cylinder, the rotatable target base device including a target base cylinder having a lateral surface, a middle part, a first end region and a second end region opposite to the first end region, wherein at least one of the first and the second end regions has a maximum outer diameter substantially equal to or less than an outer diameter of the middle part; providing a target base connection means including a fixation clamp which includes a plurality of annular segmented clamp elements, which are adapted for being closed to a clamp ring, and plurality of annular segmented clamping shells, which are adapted for encompassing a plurality of annular segmented clamp elements closed to a clamp ring and an adjoined target base support ring of a target base support, at least one of the plurality of annular segmented clamp elements optionally including an adjustment means adapted for mounting the plurality of annular segmented clamping shells on the adjoined clamp ring and target base support ring such that the annular segmented clamping shells and the annular segmented clamp elements are provided in offset circumferential positions to each other, wherein the adjustment means is optionally provided at the outer circumference of at least one of the annular segmented clamp elements; mounting the target base connection means at the at least one of the first and the second end regions of the rotatable target base device by closing the plurality of annular segmented clamp elements to a clamp ring; adjoining the clamp ring to a target base support ring of a target base support; and mounting the plurality of annular segmented clamping shells on the adjoined clamp ring and target base support ring such that the annular segmented clamping shells and the annular segmented clamp elements are provided in offset circumferential positions to each other.

Hence, according to the example illustrated in Fig. 6a to 6e, the backing tube 4 and the target base connection means including clamp 170 and clamping shell 180 may be provided. Then, the clamp 170 is mounted at one of the first and the second end regions of the backing tube 4 by closing the semicircular clamp elements 21 around recess 10 of the backing tube 4. After that, the clamp ring 170 is adjoined to target base support ring 16 of target base support 15. The semicircular clamping shells 23 of clamping shell 180 are positioned around closed clamp 170 and adjoined target base support ring 16, such that pin 172 is located in the opening 183 of clamping shell 180. Then clamping shell 180 is fastened around closed clamp 170 and adjoined target base support ring 16 using fastener 45. Since the pin 172 is positioned in the opening 183 at the interface between free ends 184, the semicircular clamping elements 23 of clamping shell 18 and the semicircular elements 21 of clamp 17 may be provided in offset circumferential positions to each other. E.g. the semicircular elements 23 and the semicircular clamping elements 21 may have a radial offset of 90°, if the pin 172 is attached in the middle of the semicircle of clamp element 21, as shown in Fig. 6b. That means that it is avoided to position the interfaces between the semicircular clamp elements 21 beneath the interfaces between semicircular clamping shells 23. Thereby, the clamping pressure may be uniformly distributed. Further, a vacuum tight fixture of the backing tube 4 to the target base support 16, which may include a vacuum seal (not shown), is provided, and leaks located in this fixture may be avoided.

The same holds for the variation of above example including a mark as an adjustment means. For providing an offset, the operator installing the backing tube 4 and the target base connection means of the present example at the target base support 15 has to ensure that the mark is visible in the gap between the closed semicircular clamping shells 23, when mounting the clamping shell 180 around clamp 170.

According to another further embodiment, a target base connection means for connecting a rotatable target base device for sputtering installations to a target base support is provided, including a fixation coupling including a fixation collar having an internal thread corresponding to an external thread provided in a fixation recess provided in the target base device, wherein the fixation recess is provided at an end of the target base device. Moreover, the at least one target base connection means may include a clamping means adapted for encompassing the fixation coupling and an adjoined target base support connection means of a target base support.

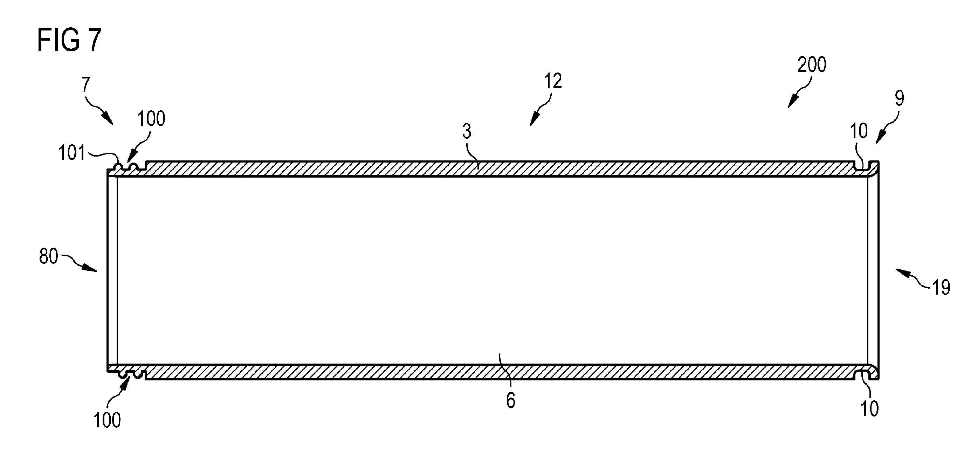

Fig. 7 shows schematically a cross sectional view of a target base cylinder 200 of a rotatable target base device according to one example of embodiments disclosed herein. This example differs from the example shown in Fig. 2 in that the end region 7 includes instead of recess 10 a recess 100 positioned at the outermost end of end region 100. Hence, recess 100 is annular, is provided at an outermost end of the target base cylinder 200 and surrounds opening 80 of the target base cylinder 200. The recess 100 is provided with an external thread 101 at the circumference of recess 100.

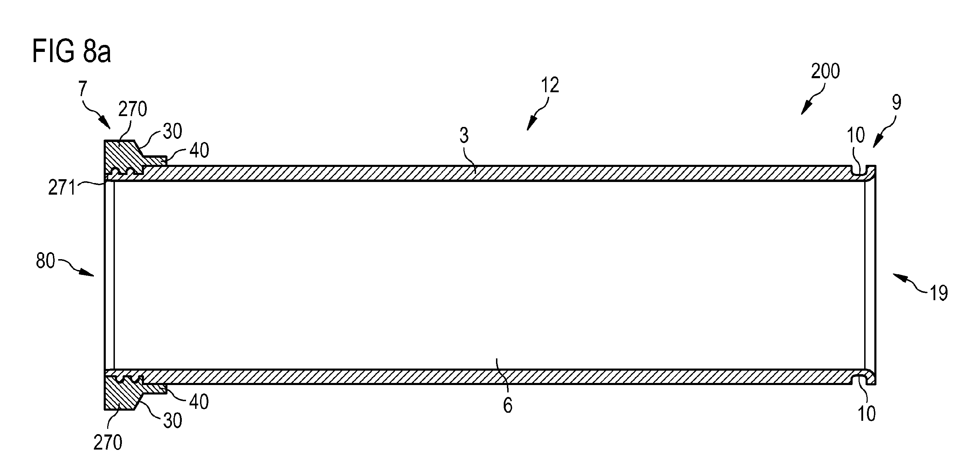

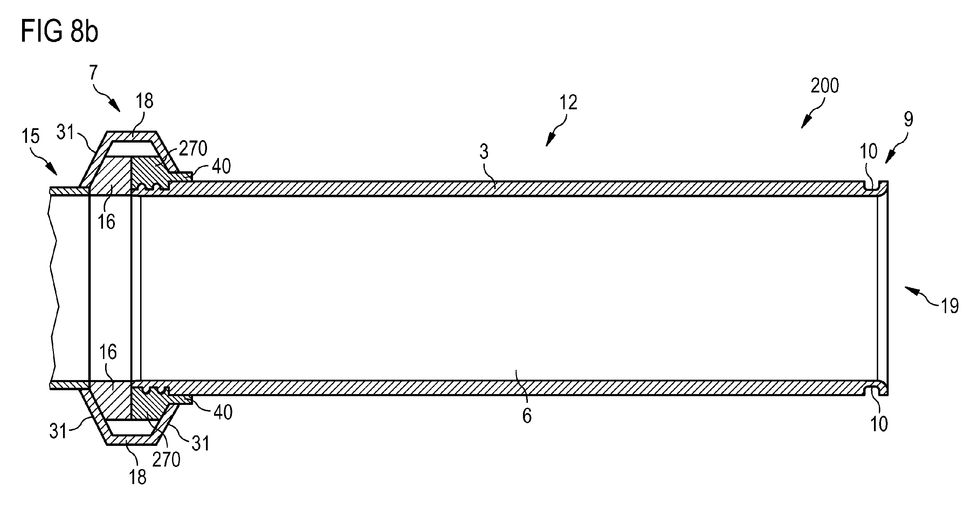

Figs. 8a and 8b illustrate schematically cross sectional views of the rotatable target base device shown in Fig. 7, provided with examples of a target base connection means according to embodiments disclosed herein. As shown in Fig. 8a, the target base connection means of the present example includes a fixation collar 270, also referred to herein as collar 270, which may be mounted on the target base cylinder 200 at recess 100. To this end, the fixation collar 270 has an internal thread 271 corresponding to the external thread 101 provided in recess 100 of target base device 200. As shown in Fig. 8b, as a clamping means, the clamping shell 18 shown in Figs. 3f and 3g may be mounted over collar 270, which is installed at the target base cylinder 200, and flange 16 of the target base support 15, when collar 270 and flange 16 are adjoined to each other. In examples of embodiments disclosed herein, the inner diameter of fixation collar 270 is suitably chosen, e.g. it is substantially equal to or slightly larger than the diameter of recess 100, in order to provide a good match of the collar 270 and the recess 100. Furthermore, the clamping shell 18 has dimensions and inner diameters allowing installation of the clamping shell 18 around the collar 270 and flange 16 of the target base support 15, when collar 270 and flange 16 are adjoined to each other. In the present example, clamping shell 18 includes two semicircular clamping shells 23 each having an outer semicircular element 28 and two chamfered lateral semicircular span elements 29 attached laterally to the outer semicircular element 28. The outer ring 25, which is formed by the outer semicircular elements 28 when closing the clamping shell 18, may have an inner diameter larger than the outer diameter of the collar 270 and the outer diameter of flange 16. Moreover, the inner diameters of the two annular span elements 27, which are formed by the lateral semicircular span elements 29 when closing the clamping shell 18, may match or be larger than the outer diameters of the backing tube 4 and of a flange socket of the target base support 15, at which the flange 16 is mounted, respectively.

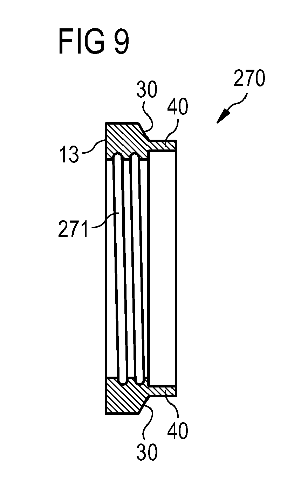

Fixation collar 270 is also shown in Fig. 9 which illustrates the internal thread 271. Moreover, fixation collar 270 may have a chamfered side face 30 and a spacer 40, as described above referring to the example of Fig. 4. In the present example of embodiments, fixation collar 270 and the flange 16 of the target base support 15 have chamfered edges resulting in chamfered side faces 30, 31, respectively. The chamfered side face 30 of fixation collar 270 is positioned opposite to the contact side 13 of the collar 270. Further, the chamfered side face 31 of the flange 16 is located opposite to the contact side of flange 16, i.e. the flange side which will contact the contact side 13 of collar 270. Moreover, the annular span elements 27 of clamping shell 18 may be correspondingly inclined, so as to span the chamfered side faces 30 and 31, when collar 270 and flange 16 are adjoined. Thereby, the annular span elements 27 may fix collar 270 and flange 16 in a vacuum tight way, when collar 270 is installed at the backing tube 45 and flange 16, which may include a vacuum seal (not shown), are adjoined to each other and clamping shell 18 is clamped over them.

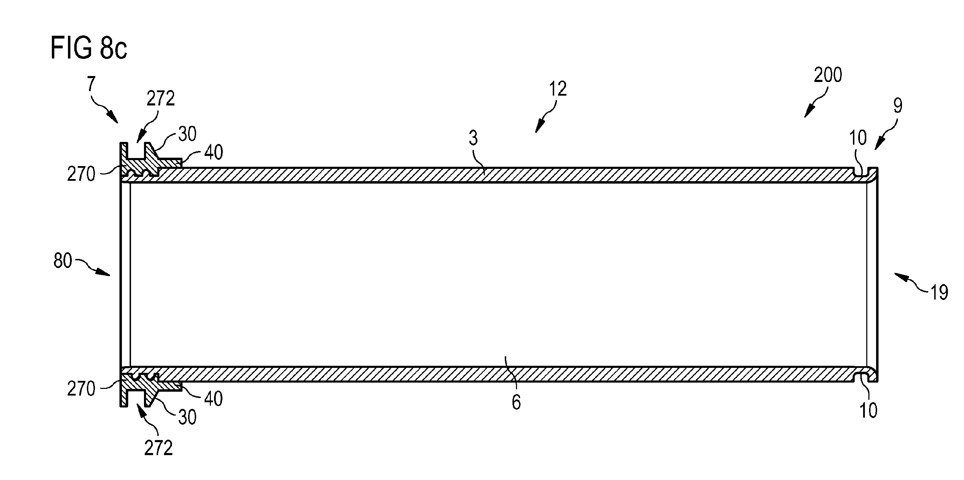

In Fig. 8c, a variation of the fixation collar 270 is shown, the variation including one or more recesses 272, e.g. a plurality of bores 272, provided in the outer circumference of fixation collar 270. The bores 272 are intended for allowing engagement of a tool, in order to facilitate mounting of the fixation collar 270 at recess 100 of the target base cylinder 200.

According to other examples (not shown) of embodiments disclosed herein, the fixation collar 270 described above may not be provided with a chamfered side face 30 and/or a spacer 40. In such cases, the clamping shell 18 is adapted and may be formed as shown in Fig. 3a.

Further, in some examples (not shown) of embodiments, the clamping means used in the examples of Fig. 7 to 9 may include a plurality of segmented clamping shells adapted for encompassing the fixation collar and an adjoined target base support connection means of a target base support, for instance as described above referring to and shown in Figs. 3 f and 3g.

In a further example (not shown) of embodiments, the fixation collar 270 shown in Figs. 8a to 8c and 9 may include an elongated spacer 40. The elongated spacer 40 may have a region, e.g. adjacent to the chamfered side face 30, having a smaller outer diameter for engagement of the clamping shell 18.

According to other examples of embodiments described herein, the target base cylinder may be provided at each end region 7 and 9 with one of the target base connection means as described above. For instance, the target base cylinder may be provided at both end regions with a recess 100, a fixation collar 270 and/or a clamping shell 18 or 180. In another example, the target base cylinder may be provided at both end regions with a recess 10, a fixation clamp 17 or 170 and/or a clamping shell 18 or 180. In further examples, the target base cylinder may be provided at one end region with a recess 100, a fixation collar 270 and/or a clamping shell 18 or 180, and at the other end region with a recess 10, a fixation clamp 17 or 170 and/or a clamping shell 18 or 180. In yet further examples, the target base cylinder may be provided at only one region 7 or 9 with one of the target base connection means as described above. For instance, the target base cylinder may be provided at only one end region either with a recess 100, a fixation collar 270 and/or a clamping shell 18 or 180, or with a recess 10, a fixation clamp 17 or 170 and/or a clamping shell 18 or 180.

Moreover, in some examples of embodiments described herein, the spacer 40 may have at its free end a height, i.e. the dimension perpendicular to the lateral surface 3 of the target base cylinder 4 when mounted thereon, in a range of about 15 mm to about 50 mm, in order to support the target cylinder reliably. This may be especially desired in case of a substantially vertical mounting of the assembled rotatable target, when the spacer 40 is part of the bottom target base connection means connected to a bottom target base support and is e.g. positioned directly below the target cylinder or below the bottom target cylinder. Moreover, in case of a vertical mounting of the assembled rotatable target, the target base cylinder may be held at its upper end region with a second target base connection means at an upper target base support. In such a case, a gap may be provided between the upper end of the target cylinder or the uppermost target cylinder and the target base connection means.

In a typical example of embodiments, the assembled rotatable target is mounted substantially vertically. Typically, in case of a substantially vertical mounting, the rotatable target may be held at its lower end by a target base connection means including a fixation collar according to examples of embodiments described herein, and may be held at its upper end by a target base connection means including a fixation clamp according to examples of embodiments described herein.

According to one embodiment, a rotatable target base device for sputtering installations is provided, wherein the target base device is adapted for receiving thereon a solid target cylinder, the rotatable target base device including a target base cylinder having a lateral surface, a middle part, a first end region and a second end region opposite to the first end region, wherein at least one of the first and the second end regions has a maximum outer diameter substantially equal to or less than the outer diameter of the middle part.

According to a modification of above one embodiment, the target base device further includes at least one target base connection means being adapted for connecting the target base cylinder to a target base support and being removable.

According to a modification of any of above one embodiment and modification thereof, the at least one of the first and the second end regions is adapted for being provided with one of the target base connection means.

According to a modification of any of above one embodiment and modifications thereof, the at least one target base connection means includes a clamping means adapted for connecting the target base cylinder to a target base support.

According to a modification of any of above one embodiment and modifications thereof, the at least one target base connection means includes a fixation coupling, and a fixation recess provided in the target base cylinder, the fixation coupling being adapted for at least partially filling the fixation recess.

According to a modification of any of above one embodiment and modifications thereof, the at least one target base connection means includes a clamping means adapted for encompassing the fixation coupling and an adjoined target base support connection means of a target base support.

According to a modification of any of above one embodiment and modifications thereof, the fixation coupling includes a fixation clamp being adapted for at least partially filling the fixation recess. According to another modification of any of above one embodiment and modifications thereof, the fixation coupling includes a fixation collar having an internal thread corresponding to an external thread provided in the fixation recess, wherein the fixation recess is provided at an end of the target base cylinder.

According to a modification of any of above one embodiment and modifications thereof, the at least one of the first and second end regions includes one fixation recess provided in the lateral surface of the target base cylinder.

According to a modification of any of above one embodiment and modifications thereof, the target base connection means includes at least one element selected from the group consisting of a or the fixation clamp having a plurality of segmented clamp elements adapted for being closed to a clamp, a or the clamping means having a clamping shell adapted for encompassing a or the fixation clamp and an adjoined target base support connection means of a target base support, a or the clamping means having a clamping shell adapted for encompassing a plurality of segmented clamp elements closed to a or the fixation clamp and an adjoined target base support connection means of a target base support, a or the clamping means having a plurality of segmented clamping shells adapted for encompassing a or the fixation clamp and an adjoined target base support connection means of a target base support, a or the clamping means having a plurality of segmented clamping shells adapted for encompassing a plurality of segmented clamp elements closed to a or the fixation clamp and an adjoined target base support connection means of a target base support, a or the clamping means having a clamping shell adapted for encompassing a or the fixation collar and an adjoined target base support connection means of a target base support, and a or the clamping means having a plurality of segmented clamping shells adapted for encompassing a or the fixation collar and an adjoined target base support connection means of a target base support.

According to a modification of any of above one embodiment and modifications thereof, the plurality of segmented clamp elements are hinged to each other and/or the plurality of segmented clamp shells are hinged to each other.

According to a modification of any of above one embodiment and modifications thereof, the target base cylinder is a tubular base cylinder, and wherein at least one element selected from the group consisting of the target base connecting means, the clamping means, the fixation coupling, the fixation recess, and the target base support connection means is annular.

According to a modification of any of above one embodiment and modifications thereof, at least one target base connection means includes a target fixation means, the target fixation means optionally being a spacer means provided at at least one element selected from the group consisting of a fixation coupling, a fixation clamp and a fixation collar of the target base connection means.

According to a modification of any of above one embodiment and modifications thereof, the rotatable target base device is adapted for a substantially vertical mounting of a rotatable target in a sputtering installation.

According to a modification of any of above one embodiment and modifications thereof, the target base cylinder includes an interior space for containing at least one element selected from the group consisting of a magnet device and a cooling system.

According to another embodiment, a rotatable target for sputtering installations is provided, including a rotatable target base device being adapted for receiving thereon a solid target cylinder, the rotatable target base device including a target base cylinder having a lateral surface, a middle part, a first end region and a second end region opposite to the first end region, wherein at least one of the first and the second end regions has a maximum outer diameter substantially equal to or less than an outer diameter of the middle part; the rotatable target base device having a solid target cylinder arranged on the lateral surface of the target base cylinder.

According to a modification of above another embodiment, the rotatable target base device has at least one of the target base connection means installed at at least one of the first and the second end region.

According to a modification of any of above another embodiment and modification thereof, a target fixation means of the target base connection means provides a gap between the solid target cylinder and the target base support.

According to a modification of any of above another embodiment and modification thereof, the solid target cylinder is tubular and is located between the first and the second end region.

According to a modification of any of above another embodiment and modification thereof, the solid target cylinder is adjusted, e.g. centered, by at least one of the target base connection means by being positioned adjacent to at least one of the target fixation means.

According to a modification of any of above another embodiment and modification thereof, the inner diameter of the solid target cylinder is substantially equal to or larger than the outer diameter of the middle part of the target base cylinder.

According to a further embodiment, a coating installation is provided, including a rotatable target base device, wherein the target base device is adapted for receiving thereon a solid target cylinder, the rotatable target base device including a target base cylinder having a lateral surface, a middle part, a first end region and a second end region opposite to the first end region, wherein at least one of the first and the second end regions has a maximum outer diameter substantially equal to or less than an outer diameter of the middle part. This embodiment may be combined with any other embodiment or modification thereof disclosed herein.

According to a yet further embodiment, a method of producing a rotatable target for sputtering installations is provided, including providing a rotatable target base device, wherein the target base device is adapted for receiving thereon a solid target cylinder, the rotatable target base device including a target base cylinder having a lateral surface, a middle part, a first end region and a second end region opposite to the first end region, wherein at least one of the first and the second end regions has a maximum outer diameter substantially equal to or less than an outer diameter of the middle part; providing a solid target cylinder; and arranging the solid target cylinder on the lateral surface of the target base cylinder; optionally including after the step of arranging the solid target cylinder a step of installing at at least one of the first and the second end region of the target base cylinder a target base connection means. This embodiment may be combined with any other embodiment or modification thereof disclosed herein.

According to another further embodiment, a target base connection means for connecting a rotatable target base device for sputtering installations to a target base support is provided, including at least one element selected from the group consisting of a fixation coupling and a fixation recess provided in the target base device, the fixation coupling being adapted for at least partially filling the fixation recess; a clamping means adapted for encompassing the fixation coupling and an adjoined target base support connection means of a target base support; a fixation clamp included in the fixation coupling and being adapted for at least partially filling a fixation recess provided in the target base device; and a fixation collar included in the fixation coupling and having an internal thread corresponding to an external thread provided in a fixation recess provided in the target base device, wherein the fixation recess is provided at an end of the target base device.

According to a modification of above another further embodiment, the target base connection means includes at least one element selected from the group consisting of the fixation clamp having a plurality of segmented clamp elements adapted for being closed to a clamp, the clamping means having a clamping shell adapted for encompassing the fixation clamp and an adjoined target base support connection means of a target base support, the clamping means having a clamping shell adapted for encompassing a plurality of segmented clamp elements closed to the fixation clamp and an adjoined target base support connection means of a target base support, the clamping means having a plurality of segmented clamping shells adapted for encompassing the fixation clamp and an adjoined target base support connection means of a target base support, the clamping means having a plurality of segmented clamping shells adapted for encompassing a plurality of segmented clamp elements closed to the fixation clamp and an adjoined target base support connection means of a target base support, the clamping means having a clamping shell adapted for encompassing the fixation collar and an adjoined target base support connection means of a target base support, and the clamping means having a plurality of segmented clamping shells adapted for encompassing the fixation collar and an adjoined target base support connection means of a target base support.

According to a modification of above another further embodiment, the fixation clamp includes a plurality of annular segmented clamp elements adapted for being closed to a clamp ring, and the clamping means includes a plurality of annular segmented clamping shells adapted for encompassing the plurality of annular segmented clamp elements closed to a clamp ring and an adjoined target base support connector ring of a target base support, at least one of the plurality of annular segmented clamp elements including an adjustment means adapted for mounting the plurality of annular segmented clamping shells on the adjoined clamp ring and target base support ring such that the annular segmented clamping shells and the annular segmented clamp elements are provided in offset circumferential positions to each other, wherein the adjustment means is optionally provided at the outer circumference of at least one of the annular segmented clamp elements.

According to a modification of any of above another further embodiment and modification thereof, the plurality of segmented clamp elements or annular segmented elements are hinged to each other, and wherein the plurality of segmented clamp shells or annular segmented clamp shells are hinged to each other.

According to a modification of any of above another further embodiment and modifications thereof, the target base connection means includes a target fixation means, the target fixation means optionally being a spacer means provided at at least one element selected from the group consisting of the fixation coupling, the fixation clamp, and the fixation collar.

According to an embodiment, a method of connecting a rotatable target base device for sputtering installations to a target base support is provided, including providing a rotatable target base device, wherein the target base device is adapted for receiving thereon a solid target cylinder, the rotatable target base device including a target base cylinder having a lateral surface, a middle part, a first end region and a second end region opposite to the first end region, wherein at least one of the first and the second end regions has a maximum outer diameter substantially equal to or less than an outer diameter of the middle part; providing a target base connection means including a fixation clamp which includes a plurality of annular segmented clamp elements, which are adapted for being closed to a clamp ring, and a plurality of annular segmented clamping shells, which are adapted for encompassing a plurality of annular segmented clamp elements closed to a clamp ring and an adjoined target base support ring of a target base support; mounting the target base connection means at the at least one of the first and the second end regions of the rotatable target base device by closing the plurality of annular segmented clamp elements to a clamp ring; adjoining the clamp ring to a target base support ring of a target base support; and mounting the plurality of annular segmented clamping shells on the adjoined clamp ring and target base support ring such that the annular segmented clamping shells and the annular segmented clamp elements are provided in offset circumferential positions to each other. This embodiment may be combined with any other embodiment or modification thereof disclosed herein.

According to a modification of any of above embodiments and modifications thereof, the rotatable target base device is adapted for a substantially vertical mounting of a rotatable target in a sputtering installation.

According to a modification of any of above embodiments and modifications thereof, the target base cylinder includes an interior space for containing at least one element selected from the group consisting of a magnet device and a cooling system.

According to a modification of any of above embodiments and modifications thereof, the inner diameter of the solid target cylinder is substantially equal to or larger than the outer diameter of the middle part of the target base cylinder.

The written description uses examples to disclose the invention, including the best mode, and also to enable any person skilled in the art to make and use the invention. While the invention has been described in terms of various specific embodiments, those skilled in the art will recognize that the invention can be practiced with modifications within the spirit and scope of the claims. Especially, mutually non-exclusive features of the examples of embodiments and embodiments or modifications thereof described above may be combined with each other. The patentable scope of the invention is defined by the claims, and may include other examples that occur to those skilled in the art. Such other examples are intended to be within the scope of the claims.

While the foregoing is directed to embodiments of the invention, other and further embodiments of the invention may be devised without departing from the basic scope thereof, and the scope thereof is determined by the claims that follow.

## Claims

1. A rotatable target base device for sputtering installations, wherein the target base device is adapted for receiving thereon a solid target cylinder, the rotatable target base device comprising
a target base cylinder (4) having a lateral surface (3), a middle part (12),
a first end region (7) and a second end region (9) opposite to the first end region,
wherein at least one of the first and the second end regions has a maximum outer diameter substantially equal to or less than an outer diameter of the middle part.

2. The rotatable target base device of claim 1, further comprising at least one target base connection means (17, 18; 170, 18; 270, 18) being adapted for connecting the target base cylinder to a target base support and being removable, and/or wherein the at least one of the first and the second end regions is adapted for being provided with one of the target base connection means.

3. The rotatable target base device of claim 2,
wherein the at least one target base connection means comprises a fixation coupling (17; 170; 270), and a fixation recess (10; 100) provided in the target base cylinder, the fixation coupling being adapted for at least partially filling the fixation recess, and/or
wherein the at least one of the first and second end regions includes one fixation recess provided in the lateral surface of the target base cylinder, and /or wherein the at least one target base connection means comprises a clamping means (18; 180) adapted for encompassing the fixation coupling and an adjoined target base support connection means of a target base support.

4. The rotatable target base device of claim 3, wherein the fixation coupling comprises at least one element selected from the group consisting of: a fixation clamp (17; 170) being adapted for at least partially filling the fixation recess (10); and
a fixation collar (270) having an internal thread (271) corresponding to an external thread (101) provided in the fixation recess (100), wherein the fixation recess (100) is provided at an end of the target base cylinder (4).

5. The rotatable target base device of any of claims 2 to 4, wherein the target base connection means comprises at least one element selected from the group consisting of the fixation clamp (17; 170) having a plurality of segmented clamp elements adapted for being closed to a clamp, the clamping means having a clamping shell (18) adapted for encompassing the fixation clamp and an adjoined target base support connection means of a target base support, the clamping means having a clamping shell (18) adapted for encompassing a plurality of segmented clamp elements (21) closed to the fixation clamp and an adjoined target base support connection means of a target base support, the clamping means having a plurality of segmented clamping shells (23) adapted for encompassing the fixation clamp and an adjoined target base support connection means (16) of a target base support, the clamping means having a plurality of segmented clamping shells (23) adapted for encompassing a plurality of segmented clamp elements (21) closed to the fixation clamp and an adjoined target base support connection means (16) of a target base support, the clamping means having a clamping shell (18) adapted for encompassing the fixation collar (270) and an adjoined target base support connection means of a target base support, and the clamping means having a plurality of segmented clamping shells (23) adapted for encompassing the fixation collar and an adjoined target base support connection means of a target base support.

6. The rotatable target base device of any of claims 1 to 5, wherein the target base cylinder is a tubular base cylinder, and/or wherein at least one element selected from the group consisting of the target base connecting means, the clamping means, the fixation coupling, the fixation recess, and the target base support connection means is annular.

7. The rotatable target base device of claim 5 or 6, wherein the plurality of segmented clamp elements are hinged to each other and/or the plurality of segmented clamp shells are hinged to each other.

8. The rotatable target base device of any of claims 2 to 7, wherein at least one target base connection means comprises a target fixation means, the target fixation means optionally being a spacer means provided at at least one element selected from the group consisting of the fixation coupling, the fixation clamp and the fixation collar.

9. A rotatable target for sputtering installations, comprising a rotatable target base device according to any of claims 1 to 8, the rotatable target base device having a solid target cylinder arranged on the lateral surface of the target base cylinder.

10. The rotatable target for sputtering installations of claim 9, the rotatable target base device having at least one of the target base connection means installed at at least one of the first and the second end region, and/or
wherein the target fixation means of the target base connection means provides a gap between the solid target cylinder and the target base support.

11. The rotatable target of claim 9 or 10, wherein the solid target cylinder is tubular, and/or is located between the first and the second end region, and /or is adjusted by at least one of the target base connection means by being positioned adjacent to at least one of the target fixation means.

12. A coating installation comprising a rotatable target base device according to any of claims 1 to 8.

13. A method of producing a rotatable target for sputtering installations, comprising
providing a rotatable target base device according to any of claims 1 to 8, providing a solid target cylinder, and
arranging the solid target cylinder on the lateral surface of the target base cylinder,
optionally comprising after the step of arranging the solid target cylinder a step of installing at at least one of the first and the second end region of the target base cylinder one of the target base connection means.

14. A target base connection means for connecting a rotatable target base device for sputtering installations to a target base support, comprising at least one element selected from the group consisting of:
a fixation coupling (17; 170; 270) and a fixation recess (10; 100) provided in the target base device, the fixation coupling being adapted for at least partially filling the fixation recess;
a clamping means (18; 180) adapted for encompassing the fixation coupling and an adjoined target base support connection means of a target base support;
a fixation clamp (17; 170) included in the fixation coupling and being adapted for at least partially filling a fixation recess (10) provided in the target base device; and
a fixation collar (270) included in the fixation coupling and having an internal thread (271) corresponding to an external thread (101) provided in a fixation recess (100) provided in the target base device, wherein the fixation recess (101) is provided at an end of the target base device.

15. The target base connection means according to claim 14, comprising at least one element selected from the group consisting of the fixation clamp (17) having a plurality of segmented clamp elements adapted for being closed to a clamp, the clamping means having a clamping shell (18) adapted for encompassing the fixation clamp and an adjoined target base support connection means of a target base support, the clamping means having a clamping shell (18) adapted for encompassing a plurality of segmented clamp elements (21) closed to the fixation clamp and an adjoined target base support connection means of a target base support, the clamping means having a plurality of segmented clamping shells (23) adapted for encompassing the fixation clamp and an adjoined target base support connection means (16) of a target base support, the clamping means having a plurality of segmented clamping shells (23) adapted for encompassing a plurality of segmented clamp elements (21) closed to the fixation clamp and an adjoined target base support connection means (16) of a target base support, the clamping means having a clamping shell adapted for encompassing the fixation collar and an adjoined target base support connection means of a target base support, and the clamping means having a plurality of segmented clamping shells adapted for encompassing the fixation collar and an adjoined target base support connection means of a target base support.

16. The target base connection means of claim 14 or 15, wherein the fixation clamp comprises a plurality of annular segmented clamp elements (21) adapted for being closed to a clamp ring, and the clamping means comprises a plurality of annular segmented clamping shells (23) adapted for encompassing the plurality of annular segmented clamp elements closed to a clamp ring and an adjoined target base support connector ring (16) of a target base support, at least one of the plurality of annular segmented clamp elements comprising an adjustment means adapted for mounting the plurality of annular segmented clamping shells on the adjoined clamp ring and target base support ring such that the annular segmented clamping shells and the annular segmented clamp elements are provided in offset circumferential positions to each other,
wherein the adjustment means is optionally provided at the outer circumference of at least one of the annular segmented clamp elements.

17. The target base connection means of claim 14 to 16, wherein the plurality of segmented clamp elements or annular segmented elements are hinged to each other, and/or wherein the plurality of segmented clamp shells or annular segmented clamp shells are hinged to each other, and/or
wherein the target base connection means comprises a target fixation means, and /or wherein the target fixation means is a spacer means provided at at least one element selected from the group consisting of the fixation coupling, the fixation clamp and the fixation collar.

18. A method of connecting a rotatable target base device for sputtering installations to a target base support, comprising
providing a rotatable target base device of any of claims 1 to 8; providing a target base connection means of any of claims 16 to 17; mounting the target base connection means at the at least one of the first and the second end regions of the rotatable target base device by closing the plurality of annular segmented clamp elements to a clamp ring; adjoining the clamp ring to a target base support ring of a target base support; and
mounting the plurality of annular segmented clamping shells on the adjoined clamp ring and target base support ring such that the annular segmented clamping shells and the annular segmented clamp elements are provided in offset circumferential positions to each other.

## Amended claims

### Amended claims in accordance with Rule 137(2) EPC.

**1.** A rotatable target base device for sputtering installations, wherein the target base device is adapted for receiving thereon a solid target cylinder, the rotatable target base device comprising
a target base cylinder (4) having a lateral surface (3), a middle part (12), a first end region (7) and a second end region (9) opposite to the first end region, wherein at least one of the first and the second end regions has a maximum outer diameter substantially equal to or less than an outer diameter of the middle part,
further comprising at least one target base connection means (270, 18) being adapted for connecting the target base cylinder to a target base support and being removable,
wherein the at least one target base connection means comprises a fixation coupling (270), and a fixation recess (100) provided in the target base cylinder, the fixation coupling being adapted for at least partially filling the fixation recess, and
wherein the fixation coupling comprises a fixation collar (270) having an internal thread (271) corresponding to an external thread (101) provided in the fixation recess (100), wherein the fixation recess (100) is provided at an end of the target base cylinder (4).

**2.** The rotatable target base device of claim 1,
wherein the fixation recess is provided in the lateral surface of the target base cylinder, and /or wherein the at least one target base connection means comprises a clamping means (18) adapted for encompassing the fixation coupling and an adjoined target base support connection means of a target base support.

**3.** The rotatable target base device of any of claims 1 to 2, wherein the target base connection means comprises at least one element chosen from the clamping means having a clamping shell (18) adapted for encompassing the fixation collar (270) and an adjoined target base support connection means of a target base support, and the clamping means having a plurality of segmented clamping shells (23) adapted for encompassing the fixation collar and an adjoined target base support connection means of a target base support.

**4.** The rotatable target base device of any of claims 1 to 3, wherein the target base cylinder is a tubular base cylinder, and/or wherein at least one element selected from the group consisting of the target base connecting means, the clamping means, the fixation coupling, the fixation recess, and the target base support connection means is annular.

**5.** The rotatable target base device of claim 3 or 4, wherein the plurality of segmented clamp shells are hinged to each other.

**6.** The rotatable target base device of any of claims 1 to 5, wherein at least one target base connection means comprises a target fixation means.

**7.** The rotatable target base device of claim 6, wherein the target fixation means is a spacer means provided at at least one element selected from the group consisting of the fixation coupling, and the fixation collar.

**8.** A rotatable target for sputtering installations, comprising a rotatable target base device according to any of claims 1 to 7, the rotatable target base device having a solid target cylinder arranged on the lateral surface of the target base cylinder.

**9.** The rotatable target for sputtering installations of claim 8, the rotatable target base device having at least one of the target base connection means installed at at least one of the first and the second end region, and/or
wherein the target fixation means of the target base connection means provides a gap between the solid target cylinder and the target base support.

**10.** The rotatable target of claim 8 or 9, wherein the solid target cylinder is tubular, and/or is located between the first and the second end region, and /or is adjusted by at least one of the target base connection means by being positioned adjacent to at least one of the target fixation means.

**11.** A coating installation comprising a rotatable target base device according to any of claims 1 to 7.

**12.** A method of producing a rotatable target for sputtering installations, comprising
providing a rotatable target base device according to any of claims 1 to 7,
providing a solid target cylinder, and
arranging the solid target cylinder on the lateral surface of the target base cylinder.

**13.** The method of claim 12, comprising after the step of arranging the solid target cylinder a step of installing at at least one of the first and the second end region of the target base cylinder one of the target base connection means.

**14.** A target base connection means for connecting a rotatable target base device for sputtering installations to a target base support, comprising
a fixation coupling (270) and a fixation recess (100) provided in the target base device, the fixation coupling being adapted for at least partially filling the fixation recess; and
a fixation collar (270) included in the fixation coupling and having an internal thread (271) corresponding to an external thread (101) provided in the fixation recess (100), wherein the fixation recess (100) is provided at an end of the target base device.

**15.** The target base connection means according to claim 14, comprising a clamping means (18) adapted for encompassing the fixation coupling and an adjoined target base support connection means of a target base support.

**16.** The target base connection means according to claim 15, comprising at least one element chosen from: the clamping means having a clamping shell adapted for encompassing the fixation collar and an adjoined target base support connection means of a target base support; and the clamping means having a plurality of segmented clamping shells adapted for encompassing the fixation collar and an adjoined target base support connection means of a target base support.

**17.** The target base connection means of claim 14 to 16, wherein the plurality of segmented clamp shells are hinged to each other, and/or
wherein the target base connection means comprises a target fixation means, and /or
wherein the target fixation means is a spacer means provided at at least one element selected from the group consisting of the fixation coupling, and the fixation collar.
